# EUROPEAN PATENT SPECIFICATION

(11) **EP 3 819 943 B1**
(45) Date of publication and mention of the grant of the patent: **10.01.2024**
(21) Application number: 19848294.5
(22) Date of filing: 06.08.2019
(51) Int. Cl.: H01L 27/15, H01L 33/48, H01L 33/64, H01L 23/373

(54) **DISPLAY DEVICE**
ANZEIGEVORRICHTUNG
DISPOSITIF D'AFFICHAGE

(30) Priority: 07.08.2018 KR 20180091664
(43) Date of publication of application: 12.05.2021
(73) Proprietor: Samsung Electronics Co., Ltd., Suwon-si 16677 (KR)
(72) Inventor: KIM, Sung Ki, Suwon-si Gyeonggi-do 16677 (KR); JUNG, Hyun Jun, Suwon-si Gyeonggi-do 16677 (KR)
(74) Representative: Gulde & Partner
(86) International application number: PCT/KR2019/009821
(87) International publication number: WO 2020/032550

(56) References cited:
- EP-A1- 2 607 949
- JP-A- 2006 343 374
- KR-A- 20050 045 350
- KR-A- 20060 068 429
- KR-A- 20080 067 848
- KR-A- 20110 132 198
- KR-A- 20130 073 816
- KR-A- 20150 033 850
- US-A1- 2006 256 530
- US-A1- 2009 290 362
- US-A1- 2011 170 017
- US-A1- 2013 213 629

## Description

### [Technical Field]

The present invention relates to a display apparatus, and more specifically, to a display apparatus including a frame supporting a display module.

### [Background Art]

In the case of light emitting diode (LED) display apparatuses using LEDs or other types of display apparatuses using backlight units (for example, liquid crystal display (LCD) type apparatuses), a reliability problem may occur due to heat generated by the LEDs.

Particularly, in the case of the LED display apparatus, heat dissipation for high heat generated by an LED module in which the plurality of LEDs are mounted may be a problem. In addition, in the case of a display apparatus in which such LED display modules are disposed in an matrix form (M and N are natural numbers), heat dissipation for high heat generated by the plurality of LED modules may be a problem, and in the case of an outdoor display apparatus, since an amount of heat generated by external heat being introduced into the outdoor display apparatus in addition to high heat generated by the LED modules is large, the heat dissipation for the heat may be a problem.

The KR 2008 0067848 A and the KR 2005 0045350 A each disclose a display apparatus including a porous member to enhance heat dissipation. The KR 2011 0132198 A discloses light emitting module including a porous member for similar use. The US 2013/213629 A1 discloses a heat dissipation substrate in which a metal layer is in contact with a second ceramic layer and a first ceramic layer, wherein metal is infiltrated in the second ceramic layer to reach an improved interface coupling between the ceramic layers and the metal layer.

In addition, like a video wall, when display apparatuses including a plurality of LED modules are attached to a wall surface or a plurality of display apparatuses are supported using separate units, an installation problem may occur due to a weight of the plurality of display apparatuses.

### [Disclosure]

### [Technical Problem]

The present invention is directed to providing a display apparatus of which a frame supporting a light emitting diode (LED) module is improved so as to improve heat dissipation performance.

The present invention is also directed to providing a display apparatus of which a frame supporting an LED module is improved so as to reduce a weight of the frame.

### [Technical Solution]

One aspect of the present invention provides a display apparatus according to claim 1.

The first region may be provided as a non-porous region.

The first region may be provided to extend from the front surface to one portion disposed between the front surface and a half of a thickness of the frame.

At least one portion of the second region includes a heat storage material.

The plurality of pores disposed in the at least one portion of the second region are provided to be filled with the heat storage material.

The plurality of pores may be provided to have diameters which increase in a direction from the front surface toward the rear surface.

The second region may further include a third surface formed of a non-porous material at one side of the second region, wherein the third surface may be provided to be exposed at the outside of the display apparatus.

At least one portion of the second region may be provided to be exposed at the outside of the display apparatus.

The display apparatus may further include an electronic part electrically connected to the printed circuit board, wherein heat generated by the electronic part may be dissipated to the plurality of outlets through the second region.

The frame further may include a seating space provided so that the electronic part may be seated inside the frame.

The electronic part may be provided inside the seating space to be in contact with at least one portion of the frame.

The plurality of LEDs mounted on the printed circuit board may be provided to directly display an image.

The display apparatus may further include an image display panel configured to display an image, wherein the plurality of LEDs mounted on the printed circuit board are provided to emit light to the image display panel.

The frame may be coupled to the cover member in a state in which a rear surface of the printed circuit board is in contact with the front surface of the frame.

Another aspect of the present invention provides a display apparatus including an LED module in which a plurality of LEDs are mounted and a frame supporting the LED module and including a porous material having a plurality of pores, wherein the frame includes a first region formed of a non-porous material, a second region formed of the porous material, and a third region, in which a heat storage material is foamed, among the second region.

The display apparatus may further include a cover member which covers one side of the frame and includes a plurality of outlets, wherein heat generated by the LED module may be dissipated to the plurality of outlets through the first region and the second region.

At least one portion of the second region may form an exterior of the display apparatus, and heat generated by the LED module may be dissipated to the outside of the display apparatus through the first region and the second region.

Still another aspect of the present invention provides a display apparatus including an LED module in which a plurality of LEDs are mounted, a frame supporting the LED module and including a front surface, and a cover member which covers a rear surface of the frame and includes a plurality of outlets, wherein the frame includes a first region extending from the front surface and having a non-porous form and a second region having a plurality of pores formed between the first region and the rear surface, wherein the first region extends from the front surface in a direction toward the rear surface.

At least one region of the second region may include a heat storage material.

The display apparatus may further include the cover member which covers the rear surface of the frame and includes the plurality of outlets, wherein heat generated by the LED module may be conducted through the first region and the second region to be dissipated to the outlets and convected through the plurality of pores to be dissipated to the outlets, and at least some of the heat may be absorbed by the heat storage material.

### [Advantageous Effects]

According to embodiments of the present invention, a frame supporting a light emitting diode (LED) module includes a multi-hole portion in which a plurality of pores are formed, and thus heat generated by the LED module can be easily dissipated through the multi-hole portion.

In addition, a weight of the frame decreases due to the multi-hole portion, and thus a weight of a display apparatus decreases so that the display apparatus can be easily installed.

### [Description of Drawings]

FIG. 1 is a perspective view illustrating a display apparatus according to one embodiment of the present invention.
FIG. 2 is an exploded perspective view illustrating the display apparatus according to one embodiment of the present invention.
FIG. 3 is a schematic side cross-sectional view illustrating a portion of the display apparatus according to one embodiment of the present invention.
FIG. 4 is a view illustrating a flow of heat dissipation in FIG. 3.
FIGS. 5 to 7 are schematic side cross-sectional views illustrating a portion of a display apparatus according to another embodiment of the present invention.
FIG. 8 is a perspective view illustrating a front surface of a display apparatus according to still another embodiment of the present invention, in which one of a plurality of light emitting diode (LED) modules is separated from a frame and illustrated.
FIG. 9 is a perspective view illustrating a rear surface of the display apparatus according to still another embodiment of the present invention.
FIG. 10 is a view illustrating a state in which the LED module is separated from the frame in the display apparatus according to still another embodiment of the present invention.
FIG. 11 is a perspective view illustrating a display apparatus according to yet another embodiment of the present invention.
FIG. 12 is a schematic side cross-sectional view illustrating the display apparatus according to yet another embodiment of the present invention.
FIG. 13 is an enlarged view illustrating a portion of FIG. 12.

### [Modes of the Invention]

Embodiments described in this specification and configurations illustrated in drawings are only exemplary examples of the disclosed invention. The invention covers various modifications that can substitute for the embodiments and drawings herein at the time of filing of this application.

In addition, the same reference numerals or symbols refer to parts or components that perform substantially the same function.

In addition, the terms used in the present specification are merely used to describe the exemplary embodiments and are not intended to limit and/or restrict the embodiments. An expression used in the singular encompasses the expression of the plural unless it has a clearly different meaning in the context. In the present specification, the terms such as "including," "having," and "comprising" are intended to indicate the presence of the features, numbers, steps, actions, components, parts, or combinations thereof disclosed in the specification, and are not intended to preclude the possibility that one or more other features, numbers, steps, actions, components, parts, or combinations thereof may be present or added.

In addition, it should be understood that, although the terms "first," "second," and the like may be used herein to describe various elements, these elements should not be limited by these terms. These terms are only used to distinguish one element from another element. For example, a first element could be termed a second element, and, similarly, a second element could be termed a first element, without departing from the scope of the present invention. As used herein, the term "and/or" includes one or combinations of the associated listed items.

As used herein, the term "and/or" includes one or combinations of the associated listed items.

Content may be disposed on a display apparatus. The content may be received from a controller which is connected to the display apparatus and controls the display apparatus and/or from another display apparatus connected thereto. In addition, the content may be received from an external server. For example, the content may include a video file or audio file which will be played by a video player that is one application, a music file which will be played by a music player, a photo file which will be displayed by a photo gallery, a web page file or text file which will be displayed by a web browser, and the like. In addition, the content may include broadcasts being received.

Hereinafter, embodiments according to the present invention will be described in detail with reference to the accompanying drawings.

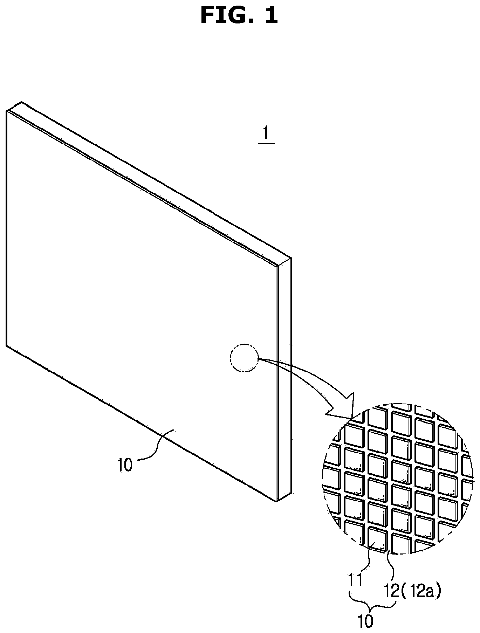

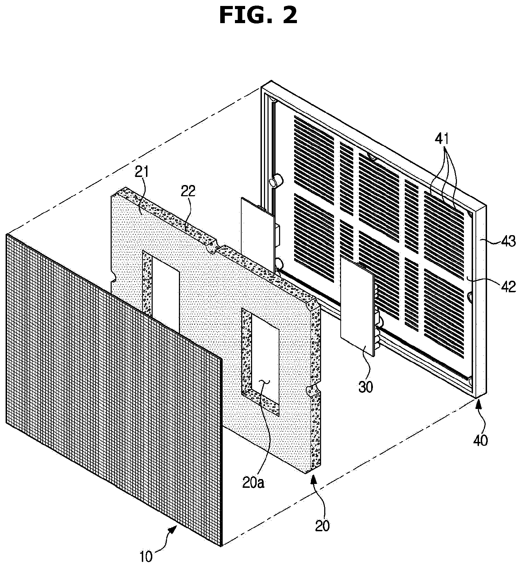

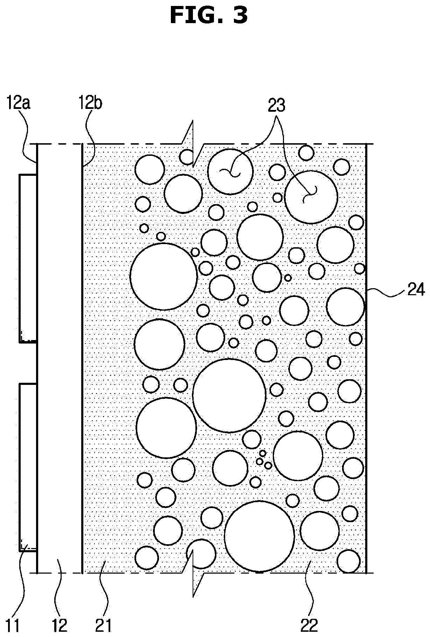

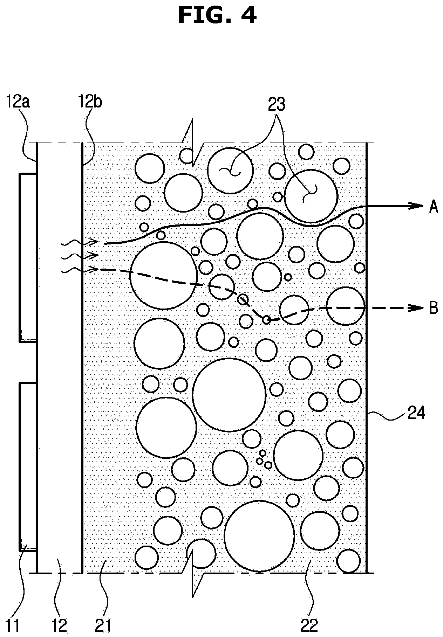

FIG. 1 is a perspective view illustrating a display apparatus according to one embodiment of the present invention, FIG. 2 is an exploded perspective view illustrating the display apparatus according to one embodiment of the present invention, FIG. 3 is a schematic side cross-sectional view illustrating a portion of the display apparatus according to one embodiment of the present invention, and FIG. 4 is a view illustrating a flow of heat dissipation in FIG. 3.

A display apparatus 1 may include a light emitting diode (LED) module 10. The LED module 10 may include a plurality of LEDs 11 and a printed circuit board 12 on which the plurality of LEDs 11 are mounted. The printed circuit board 12 may include a mounting surface 12a on which the plurality of LEDs 11 are mounted.

The LED module 10 may be implemented by arranging the LEDs, which emit red light, green light, and blue light, in a matrix form.

The LED module 10 may include pixels in the matrix form, wherein one pixel is formed by packaging a red LED (not shown), a green LED (not shown), and a blue LED (not shown). Each of the red LED, the green LED, and the blue LED which form one pixel may be referred to as a sub pixel. The pixel may be implemented with LEDs which emit a white color and color filters which filter the white color into various colors.

In the plurality of LEDs 11, one pixel may be formed with the red LED, the green LED, and blue LED which are the sub pixels, and the pixel may be repeatedly arrayed.

The plurality of LEDs 11 may be mounted on the mounting surface 12a in the form of the matrix (for example, MxN, here, M and N are natural numbers). The matrix may be a square matrix (for example, M=N, here, M and N are natural numbers, a 16x16 array, and a 24x24 array), or a rectangular matrix (for example, M≠N, herein, M and N are natural numbers).

The LED module 10 may form a screen using the plurality of LEDs 11. The LED module 10 may display content by driving the plurality of LEDs 11.

The display apparatus 1 may include a frame 20 supporting the LED module 10. The frame 20 may include a support surface supporting an opposing surface 12b opposite to the mounting surface 12a of the LED module 10 to support the opposing surface 12b opposite to the mounting surface 12a in a state in which the frame 20 is in contact with the LED module 10.

The display apparatus 1 may include an electronic part 30 which is electrically connected to the LED module 10 and through which an electrical signal is transmitted to the LED module 10 so that an image is displayed on the LED module 10.

The electronic part 30 may be seated in a seating space 20a provided in the frame 20. The seating space 20a is an open space that is open outward from an inner side of the frame 20, and a shape thereof may be changed according to a size of the electronic part 30 and may be at least greater than the size of the electronic part 30.

The display apparatus 1 may include a cover member 40 which covers a rear surface 24 of the frame 20. The cover member 40 may include a plurality of outlets 41 provided to discharge heat generated in the display apparatus 1.

The cover member 40 may include a rear surface portion 42 which covers the rear surface 24 of the frame 20 and in which the plurality of outlets 41 are provided and a side surface portion 43 which extends from the rear surface portion 42 and covers the side surface of the frame 20.

However, the present invention is not limited thereto, and the cover member 40 may not include the side surface portion 43 and may include only the rear surface portion 42. In this case, at least a portion of the frame 20 may be exposed at the outside of the display apparatus 1.

Although will be described below, since a second region 22 of the frame 20 is exposed at the outside of the display apparatus 1, heat which is convected in a plurality of pores 23 of the second region 22 may be directly discharged to the outside of the display apparatus 1 through the second region 22 without the need to be discharged to the outside of the display apparatus 1 through the plurality of outlets 41.

As described above, the frame 20 may be disposed in contact with the LED module 10 to support the LED module 10. Specifically, the opposing surface 12b of the printed circuit board 12 may be disposed in contact with a front surface of the frame 20.

The opposing surface 12b of the printed circuit board 12 may be attached to the front surface of the frame 20 by an adhesive member and the like to face each other. In addition, in a state in which the printed circuit board 12 and the frame 20 are provided in contact with each other, the printed circuit board 12 and the frame 20 may be coupled to the cover member 40.

The frame 20 may be coupled to the cover member 40 through various coupling methods such as a screw-coupling method and by coupling components. That is, since the printed circuit board 12 is coupled to the cover member 40 in the state in which the printed circuit board 12 is coupled to the frame 20, additional components are not needed by the printed circuit board 12 for coupling with the cover member 40, and thus, the printed circuit board 12 may be easily coupled to the cover member 40 by the frame 20.

A first region 21 including a non-porous material that does not include a plurality of pores may be formed in the front surface of the frame 20.

The first region 21 may be any one region, which extends from the front surface of the frame 20 in a direction toward the rear surface 24 thereof, of the frame 20. The first region 21 is a non-porous region, and the first region 21 and the second region 22, which will be described below, may be distinguished according to whether the plurality of pores 23 are included in the corresponding region.

The second region 22 may be a region formed between the first region 21 and the rear surface 24. The second region 22 may be the region including the plurality of pores 23 and may be formed of a porous material.

The first region 21 and the second region 22 may be integrally formed of the same material. However, the present invention is not limited thereto, the first region 21 and the second region 22 may be integrally formed of different materials, the present invention is not limited thereto, and the first region 21 and the second region 22 may be individually formed and then assembled.

Heat at a high temperature may be generated in the LED type display apparatus 1 including the LED module 10 in which the plurality of LEDs 11 are mounted as described in one embodiment of the present invention, and thus the reliability of the display apparatus 1 may be degraded.

In the case of a front surface of the display apparatus 1, even when heat is generated, the front surface may be easily cooled due to natural convection to the outside, but, heat transferred to a rear surface of the LED module 10 (the opposing surface 12b of the printed circuit board) is not easily cooled. In addition, since the electronic part 30 is disposed on the rear surface of the LED module 10, heat is additionally generated, and thus dissipation of heat generated by the opposing surface 12b of the printed circuit board 12 may be a problem.

In addition, in a case in which the display apparatus 1 is used outdoors, a problem in that an internal temperature of the display apparatus 1 further increases due to sunlight may occur, and in a case in which a plurality of display apparatuses 1 are used in the form of a video-wall, since heat generated by the plurality of display apparatuses 1 is added thereto, internal heat dissipation of the display apparatus 1 may become a more serious problem.

In order to solve such problems, in the display apparatus 1 according to one embodiment of the present invention, since the frame 20 includes the second region 22 having the plurality of pores 23, the internal heat dissipation of the display apparatus 1 or heat dissipation from the opposing surface 12b of the printed circuit board 12 may be more easily performed when compared to a conventional display apparatus.

Specifically, in a conventional case, heat generated by an LED module may be discharged to a cover member through a frame disposed in contact with an LED module due to heat conduction, however, in the frame 20 of the present invention, since heat is conducted through the frame 20 and simultaneously heat convection occurs in the plurality of pores 23 formed in the frame 20, the heat may be additionally discharged toward the cover member 40.

That is, since the frame 20 includes the second region 22 formed of the porous material including the plurality of pores 23, the heat dissipation performance of the frame 20 may be improved.

Accordingly, the heat dissipation performance of the display apparatus 1 may be improved even when the display apparatus 1 does not include an additional component such as a fan. In addition, since the plurality of pores 23 are formed in the frame 20, a weight of the frame 20 decreases, and thus, a total weight of the display apparatus 1 decreases so that the display apparatus 1 may be easily installed.

Recently, a trend is increasing in which the display apparatus is attached to a wall as a wall-mount type display apparatus. In this case, when the weight of the display apparatus decreases, since it is easy to attach the display apparatus to the wall, installability of the display apparatus may be improved. In addition, in a case in which the plurality of display apparatuses are attached to the wall like the video-wall, when the weight of the display apparatuses decreases, the installation reliability thereof may be improved.

As described above, the first region 21 is the region which does not include the plurality of pores 23 so that adhesiveness may be improved between the first region 21 and the printed circuit board 12. That is, since the first region 21 does not include the plurality of pores 23, an area in which the opposing surface 12b of the printed circuit board 12 is in contact with the first region 21 increases, and thus, an area of the first region 21 capable of supporting the printed circuit board 12 may increase.

In addition, since the area in which the first region 21 is in contact with the opposing surface 12b of the printed circuit board 12 increases, an amount of heat generated by the printed circuit board 12 and conducted to the first region 21 may be maximized. Accordingly, the heat dissipation performance of the frame 20 may be improved.

The first region 21 may be formed as a region having a predetermined thickness from the front surface of the frame 20 but is not limited thereto, and the first region 21 may be formed only on the front surface of the frame 20.

In addition, the first region 21 may be additionally formed on the side surface and the like of the frame 20 in addition to the front surface of the frame 20. That is, in a case in which the stiffness of the frame 20 is secured or a region in which the plurality of pores 23 are not disposed is required, a non-porous region may also be provided at a position in addition to a position of the front surface of the frame 20.

Heat generated by the printed circuit board 12 may be conducted to the first region 21 through the opposing surface 12b of the printed circuit board 12. The heat conducted to the first region 21 may be conducted to the rear surface 24 of the frame 20 through the first region 21 and a non-porous region of the second region 22 and discharged to the outside of the display apparatus 1 through the outlets 41 of the cover member 40 disposed on the rear surface 24 of the frame 20. (Passage A)

In addition, the heat conducted to the first region 21 may be introduced into the plurality of pores 23 through the first region 21, convected to the rear surface 24 of the frame 20 through air in the plurality of pores 23, and discharged to the outside of the display apparatus 1 through the outlets 41 of the cover member 40 disposed on the rear surface 24 of the frame 20. (Passage B).

That is, the heat generated by the LED module 10 may be discharged to the outside of the display apparatus 1 due to conduction (passage A) and convection (passage B).

In addition, in the heat conduction (passage A), since the plurality of pores 23 are formed in the frame 20 of the display apparatus 1 according to one embodiment of the present invention, an area in which heat comes into contact with the frame 20 increases as much as the plurality of pores 23 are formed, and thus efficiency of heat conduction (passage A) may be improved in addition to an additional increase in heat dissipation passage due to heat convection (passage B) when compared to the conventional frame.

In addition, although not clearly illustrated in the drawings, the electronic part 30 seated in the seating space 20a of the frame 20 may be disposed in contact with the frame 20. Accordingly, heat generated by the electronic part 30 may be conducted to the frame 20, transferred to the rear surface of the frame 20 from the second region 22 due to conduction or convection, and discharged to the outside of the display apparatus 1 through the outlets 41 of the cover member 40.

Hereinafter, a frame 20 of a display apparatus according to another embodiment of the present invention will be described. Since components, except components which will be described below, of another embodiment of the present invention are the same as those of the above-described display apparatus 1 according to one embodiment of the present invention, the descriptions thereof will be omitted.

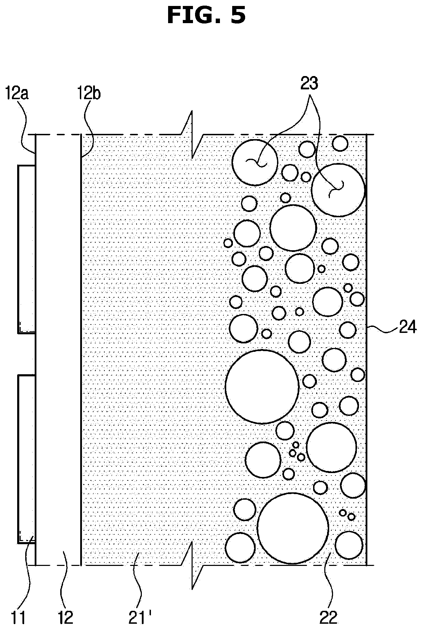

FIGS. 5 to 7 are schematic side cross-sectional views illustrating a portion of a display apparatus according to another embodiment of the present invention.

As illustrated in FIG. 5, a first region 21' may extend from a front surface of the frame 20 in a direction toward a rear surface 24 thereof to have a predetermined thickness. That is, the first region 21' may include a longitudinal portion extending from the front surface of the frame 20 to the rear surface 24. The longitudinal portion may extend by a predetermined length between the front surface of the frame 20 and a half of a thickness of the frame 20. However, the present invention is not limited thereto, and the first region 21' may extend one of various lengths from the front surface of the frame 20 toward the rear surface 24.

When the thickness of the first region 21' increases in the frame 20, heat capacity capable of receiving the heat generated by a printed circuit board 12 may increase, and when the first region 21' increases, the stiffness of the frame 20 may be further improved.

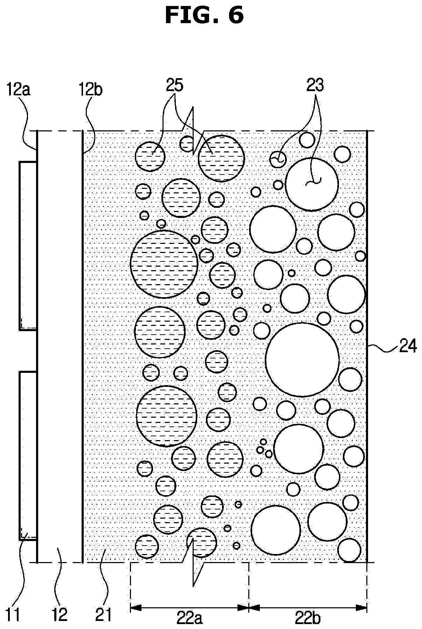

As illustrated in FIG. 6, the frame 20 includes a heat storage material 25 foamed in a plurality of pores 23 of a second region 22 and configured to absorb heat due to phase change. That is, a predetermined region (hereinafter, referred to as a third region 22a) of the second region 22 is a region including the heat storage material 25, and the heat storage material 25 fills the plurality of pores 23 disposed in the third region 22a.

After the heat storage material 25 fills the third region 22a in a liquid state, the heat storage material 25 may be seated in the plurality of pores 23 of the third region 22a in a solid state.

Accordingly, even when high heat is suddenly generated by the printed circuit board 12, the heat storage material 25 foamed in the third region 22a may absorb some of the high heat. The heat storage material 25 may absorb the heat in a phase change process, in which the solid state is changed to the liquid state, to maintain a temperature of the third region 22a for a predetermined period.

That is, even when high heat generation pitches of some heating components increase, the temperature of the third region 22a may be maintained for the predetermined period and a temperature of the entirety of the frame 20 may not increase quickly due to the heat storage material 25. Accordingly, the remaining heat may be conducted through the second region 22 and convected through the plurality of pores 23 disposed in the region 22b, in which the heat storage material 25 is not foamed, in the second region 22 so that the heat of the display apparatus 1 may be easily dissipated.

That is, heat dissipation efficiency may be improved due to the heat storage material 25 disposed in the third region 22a through the conduction, convection, and phase change in the frame 20. In a conventional case, the heat of a display apparatus is dissipated only through heat conduction of a frame, but in the display apparatus 1 according to another embodiment of the present invention, high efficiency of heat dissipation of the display apparatus 1 may be achieved by absorbing some heat due to phase change in addition to heat conduction and heat convection.

In order to improve the heat dissipation efficiency of the third region 22a of the frame 20, the third region 22a may be disposed close to heating components. That is, as the first region 21 disposed close to the printed circuit board 12 is disposed close to the third region 22a, the third region 22a may absorb some of high heat conducted from the first region 21 so that a temperature of the third region 22a may be maintained for a predetermined period.

However, the present invention is not limited thereto, and the third region 22a may be provided in a different region of the second region 22 in consideration of factors such as a pressure decrease and the like when heat convection occurs according to arrangement of plurality of pores 23.

The heat storage material 25 capable of undergoing a phase change is not applied on inner portions of the plurality of pores 23, but a separate member may be inserted into the first region 21 or disposed between the frame 20 and the printed circuit board 12. However, in this case, since a contact area in which the heat storage material 25 is in contact with the components to which heat is conducted decreases, phase change efficiency may decrease.

That is, since the heat storage material 25 is disposed in the plurality of pores 23, the contact area in which the heat storage material 25 is in contact with the components to which the heat is conducted may increase but, when the heat storage material 25 is simply disposed between components formed of non-porous materials, the heat conduction efficiency of a portion except the area in which the components are in contact with each other decreases, and thus, overall phase change efficiency of the heat storage material 25 may decrease.

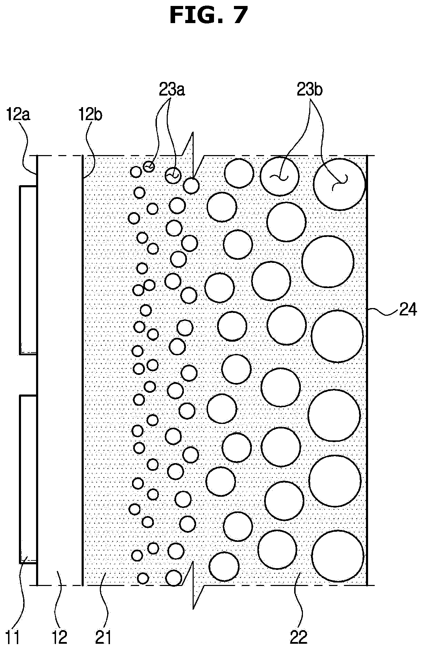

As illustrated in FIG. 7, the plurality of pores 23 of the second region 22 may be provided so that diameters of the plurality of pores 23 increase in a direction from the first region 21 toward the rear surface 24 of the frame 20.

That is, the diameters of the plurality of pores 23a disposed close to the first region 21 may be relatively small, and the diameters of the plurality of pores 23b frame 20 disposed close to the rear surface 24 may be greater than the diameters of the plurality of pores 23a disposed close to the first region 21.

This is to allow some heat, which is convected through the plurality of pores 23, of heat conducted from the first region 21 to easily flow to the rear surface 24 of the frame 20. That is, the heat convected between the plurality of pores 23 may be introduced into outlets 41 of a cover member 40 through the rear surface 24 of the frame 20 to be discharged to the outside of the display apparatus 1, and when the diameters of the plurality of pores 23 gradually increase in the direction from the front surface of the frame toward the rear surface 24, heat may be easily guided to be convected to the rear surface 24 of the frame 20.

Accordingly, the convected heat may be easily guided to be discharged to the outside of the display apparatus 1, and convection efficiency increases so that heat dissipation performance of the display apparatus 1 may be increased.

Hereinafter, embodiments in which the frame 20, which is described above, is applied to different kinds of display apparatuses will be described.

The components of the frame 20 or 20', except a component which will be described below, include the first region 21 and the second region 22 including the plurality of pores 23 like the frame 20, and the repeated description thereof will be omitted. In addition, the frame 20 may also further include the third region 22a described above.

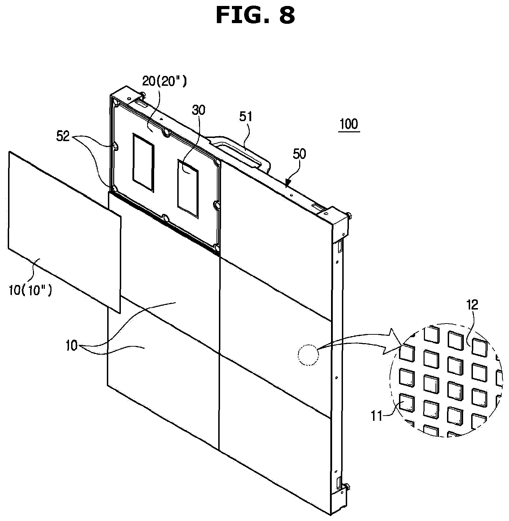

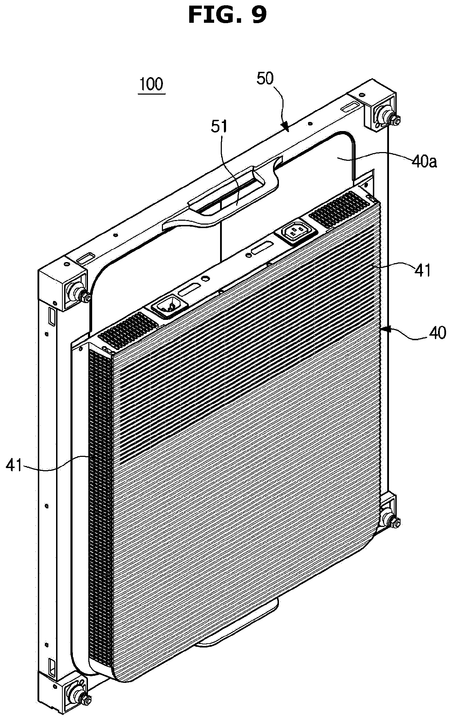

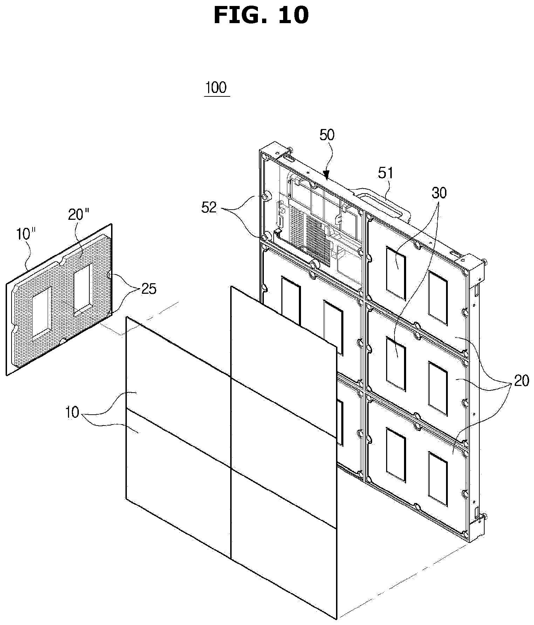

FIG. 8 is a perspective view illustrating a front surface of a display apparatus according to still another embodiment of the present invention, in which one of a plurality of light emitting diode (LED) modules is separated from a frame and illustrated, FIG. 9 is a perspective view illustrating a rear surface of the display apparatus according to still another embodiment of the present invention, and FIG. 10 is a view illustrating a state in which the LED module is separated from the frame in the display apparatus according to still another embodiment of the present invention.

A display apparatus 100 may include a plurality of LED modules 10. Each of the LED module 10 may include a plurality of LEDs 11 and display content using the plurality of LEDs 11.

The plurality of LED modules 10 arrayed in a matrix form may be installed in frames 20. In the frame 20, one LED module or the plurality of LED modules 10 arrayed in the matrix (MxN, here, M and N are natural numbers) form may be installed. Referring to FIGS. 8 to 10, although the LED modules 10 are arrayed in a 2x3 form, it will be easily understood by those skilled in the art that the number and an arrangement pattern of the LED modules formed in the matrix form may be variously changed.

Edges of the frames 20 may include an additional auxiliary frame 50. The auxiliary frame 50 may be formed in a quadrilateral shape to form a side exterior of the display apparatus 100. A handle 51 may be provided on the auxiliary frame. The auxiliary frame 50 may be formed in a form surrounding a side surface of the frame or at least a portion of a rear surface thereof to further secure stiffness of the display apparatus 100.

The auxiliary frame 50 may be provided as a component separate from the frame 20 like still another embodiment of the present invention, or the auxiliary frame 50 may be formed as a component integrated with the frame 20. In this case, the auxiliary frame 50 may include a first region 21, a second region 22, and a plurality of pores 23 provided in the second region 22 like the frame 20.

A cover member 40 which covers the frame 20 may be disposed behind the frame 20 and the auxiliary frame 50. The cover member 40 may include a plurality of outlets 41 to discharge heat conducted and convected through the frame 20 to the outside of the display apparatus 100 through the plurality of outlets 41.

The cover member 40 may be formed to protrude in a rearward direction of the display apparatus 100 to easily cover a plurality of electronic parts 30 disposed in the display apparatus 100. The electronic part 30 may be disposed inside a seating space 20a formed inside the frame 20, and as described above, the electronic part 30 may be additionally disposed inside the cover member 40. In addition, the electronic part 30 may be disposed only inside the cover member 40. In addition, the electronic part 30 may be disposed only inside the seating space 20a formed inside the frame 20. In addition, in a case in which the cover member 40 protruding in the rearward direction does not cover an entire rear side of the display apparatus 100, as illustrated in FIG. 9, an auxiliary cover member 40a may be additionally provided. However, the present invention is not limited thereto, and the cover member 40 and the auxiliary cover member 40a may be integrally formed.

The number of frames 20 may be provided to correspond to the number of the plurality of LED modules 10. Referring to FIG. 10, since the plurality of LED modules 10 are arrayed in a 2x3 form, the plurality of frames 20 may be also provided in a 2x3 form corresponding to plurality of LED modules 10.

The plurality of frames 20 may be coupled to rear surfaces of the plurality of LED modules 10. That is, any one frame 20" of the plurality of frames 20 may be coupled to a rear surface of any one LED module 10" of the plurality of LED modules 10.

The plurality of frames 20 may be coupled to the auxiliary frame 50. The plurality of frames 20 may be coupled to the auxiliary frame 50 by coupling parts 52 provided on the auxiliary frame 50 in a state in which the plurality of LED modules 10 are coupled to the plurality of frames 20.

The plurality of frames 20 may include coupling grooves 25 coupled to the coupling parts 52. The coupling parts 52 and the coupling grooves 25 may include magnetic materials so that the coupling parts 52 and the coupling grooves 25 may be magnetically coupled to each other, but the present invention is not limited thereto, and the coupling parts 52 and the coupling grooves 25 may be coupled through various methods such as a physical insertion-coupling method and a screw-coupling method.

However, the present invention is not limited thereto, and one frame 20 may be provided. The frame 20 may be formed to have a size corresponding to a size in which the plurality of LED modules 10 are arrayed so that the plurality of LED modules 10 may be coupled to one frame 20.

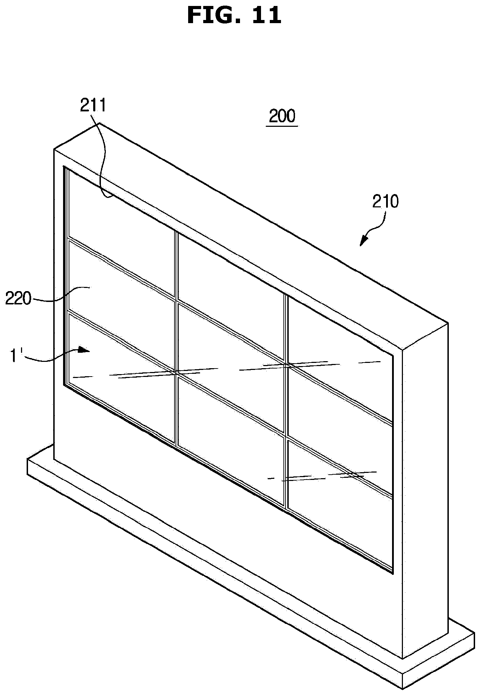

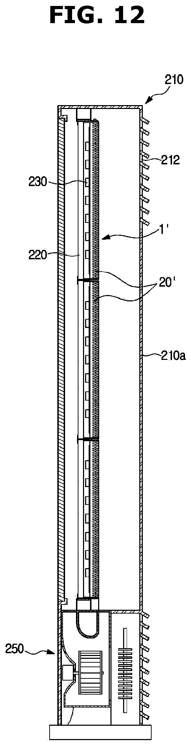

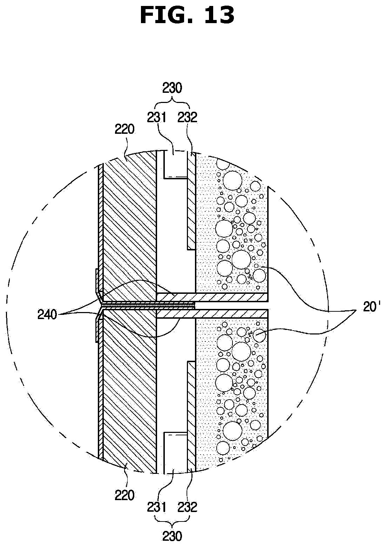

FIG. 11 is a perspective view illustrating a display apparatus according to yet another embodiment of the present invention, FIG. 12 is a schematic side cross-sectional view illustrating the display apparatus according to yet another embodiment of the present invention, and FIG. 13 is an enlarged view illustrating a portion of FIG. 12.

In the case of the display apparatus 1 or 100 described above, an LED display type has been be described, but a frame 20, which will be described below, may be applied to a display apparatus 200 as a liquid crystal display (LCD) type in addition to the LED type display apparatus.

As illustrated in FIG. 11, the display apparatus 200 according to yet another embodiment of the present invention may be installed outdoors. However, the present invention is not limited thereto, and it is clear that the frame 20 is may be applied to a liquid crystal display (LCD) type display apparatus which may be used indoors.

An opening 211 is formed in a front surface of a housing 210 of the display apparatus 200, and the housing 210 may include glass provided in the opening 211. The glass may include a transparent member having sufficient stiffness such as tempered glass for reliability of the display apparatus 200. The glass may be formed to have a size corresponding to a plurality of display panels 220 formed in the housing 210 and may allow an image displayed on the display panels 220 installed in the housing 210 to be viewed.

Although the plurality of display panels 220 are installed in the display apparatus 200 to implement an outdoor video-wall in yet another embodiment of the present invention, the number of the display panels 220 are not limited thereto, and one display panel 220 may be disposed in the display apparatus 200.

As illustrated in FIG. 12, the display panels 220 on which an image is displayed and backlight units 230 configured to emit light to the display panels 220 may be disposed in the housing 210.

In addition, an air circulation device 250 configured to circulate external air through an inner portion of the housing 210 to maintain a constant temperature in the housing 210 may be provided in the housing 210. In addition, outlets 212 formed in a rear surface 210a of the housing 210 may be provided to discharge heat generated by the backlight units 230.

Although not illustrated in the drawings, the backlight units 230 may further include various components such as diffusing films, optical films, reflective films, and the like which guide light emitted by a plurality of LEDs 231 to be emitted to the display panel 220. For the sake of convenience in the description, descriptions and illustration thereof will be omitted.

Heat generated by the backlight unit 230 may be discharged through the outlets 212 due to natural heat conduction and heat convection and further discharged through the outlets 212 by the air circulation device 250.

The backlight unit 230 may be supported by a frame 20' in the housing 210. The frame 20' may be provided in contact with a rear surface of a printed circuit board 232, on which the plurality of LEDs 231 of the backlight unit 230 are mounted, to easily support the printed circuit board 232.

In addition, unlike the yet another embodiment of the present invention, in the case of a LCD apparatus in which components such as a light guide plate and the like are required, since a frame 20' may support the entirety of a backlight unit 230 in addition to a printed circuit board 232, heat generated by components except the printed circuit board 232 may be easily dissipated.

The number of frames 20' may be provided to correspond to the plurality of display panels 220. In addition, the plurality of frames 20' may be supported by a connecting member 240 disposed between the plurality of frames 20'.

The connecting member 240 may further support the plurality of display panels 220. Accordingly, heat generated by the display panel 220 may be conducted to the plurality of frames 20' through the connecting member 240 so that the heat generated by the display panel 220 may also be easily dissipated.

The printed circuit board 232 provided as a plurality of printed circuit boards 232 is disposed in contact with each of the plurality of frames 20', and the plurality of frames 20' may be coupled to the housing 210 by the connecting member 240.

However, the present invention is not limited thereto, and one frame 20' may be formed to support the plurality of backlight units 230 corresponding to the plurality of display panels 220.

As described above, heat generated by the backlight unit 230 may be transferred to a rear side of the frame 20' through the frame 20' due to heat conduction and heat convection and discharged to the outside of the display apparatus 200 through the plurality of outlets 212 disposed behind the frame 20'.

Here, in the case of a front side of the backlight unit 230, natural convection may occur due to the air circulation device 250, and heat transferred to the rear side of the frame 20' may also be easily transferred to the outlets 212 by the air circulation device 250 to be discharged to the outside of the display apparatus 200.

In addition, although not illustrated in the drawings, in the case of an indoor LCD apparatus, when an air circulation device 250 is not disposed in a display apparatus, heat may be discharged to the outside of the display apparatus due to heat conduction and heat convection of a frame 20'. In the case of the indoor display apparatus, unlike the display apparatus 200 which may be installed outdoors, illustrated in FIGS. 11 to 13, since a phenomenon in which heat in a display apparatus 200 rises due to external heat does not occur, the heat of the display apparatus may be sufficiently dissipated only by dissipating heat of the frame 20'.

While specific embodiments of the preset invention have been illustrated and described above in detail, the embodiments may be variously modified by those skilled in the art without departing from the gist of the technological scope of the present invention defined by the appended claims.

Although not illustrated in the drawings, the backlight units 230 may further include various components such as diffusing films, optical films, reflective films, and the like which guide light emitted by a plurality of LEDs 231 to be emitted to the display panel 220. For the sake of convenience in the description, descriptions and illustration thereof will be omitted.

Heat generated by the backlight unit 230 may be discharged through the outlets 212 due to natural heat conduction and heat convection and further discharged through the outlets 212 by the air circulation device 250.

The backlight unit 230 may be supported by a frame 20' in the housing 210. The frame 20' may be provided in contact with a rear surface of a printed circuit board 232, on which the plurality of LEDs 231 of the backlight unit 230 are mounted, to easily support the printed circuit board 232.

In addition, unlike the yet another embodiment of the present invention, in the case of a LCD apparatus in which components such as a light guide plate and the like are required, since a frame 20' may support the entirety of a backlight unit 230 in addition to a printed circuit board 232, heat generated by components except the printed circuit board 232 may be easily dissipated.

The number of frames 20' may be provided to correspond to the plurality of display panels 220. In addition, the plurality of frames 20' may be supported by a connecting member 240 disposed between the plurality of frames 20'.

The connecting member 240 may further support the plurality of display panels 220. Accordingly, heat generated by the display panel 220 may be conducted to the plurality of frames 20' through the connecting member 240 so that the heat generated by the display panel 220 may also be easily dissipated.

The printed circuit board 232 provided as a plurality of printed circuit boards 232 is disposed in contact with each of the plurality of frames 20', and the plurality of frames 20' may be coupled to the housing 210 by the connecting member 240.

However, the present invention is not limited thereto, and one frame 20' may be formed to support the plurality of backlight units 230 corresponding to the plurality of display panels 220.

As described above, heat generated by the backlight unit 230 may be transferred to a rear side of the frame 20' through the frame 20' due to heat conduction and heat convection and discharged to the outside of the display apparatus 200 through the plurality of outlets 212 disposed behind the frame 20'.

Here, in the case of a front side of the backlight unit 230, natural convection may occur due to the air circulation device 250, and heat transferred to the rear side of the frame 20' may also be easily transferred to the outlets 212 by the air circulation device 250 to be discharged to the outside of the display apparatus 200.

In addition, although not illustrated in the drawings, in the case of an indoor LCD apparatus, when an air circulation device 250 is not disposed in a display apparatus, heat may be discharged to the outside of the display apparatus due to heat conduction and heat convection of a frame 20'. In the case of the indoor display apparatus, unlike the display apparatus 200 which may be installed outdoors, illustrated in FIGS. 11 to 13, since a phenomenon in which heat in a display apparatus 200 rises due to external heat does not occur, the heat of the display apparatus may be sufficiently dissipated only by dissipating heat of the frame 20'.

While specific embodiments of the preset invention have been illustrated and described above in detail, the embodiments may be variously modified by those skilled in the art, the invention is as defined in the appended claims.

## Claims

1. A display apparatus comprising:
a printed circuit board (12) on which a plurality of light emitting diodes, LEDs, (11) are mounted;
a frame (20) including a front surface configured to support the printed circuit board (12); and
a cover member (40) which covers a rear surface (24) of the frame (20),
wherein the frame (20) includes a first region (21) extending in a direction from the front surface toward the rear surface (24) and a second region (22) including a plurality of pores (23) formed between the first region (21) and the rear surface (24), and
the cover member (40) includes a plurality of outlets (41), wherein
heat generated by the printed circuit board (12) is convected to the plurality of outlets (41) through the first region (21) and the plurality of pores (23), and
**characterised in that** at least one portion (22a) of the second region (22) includes a heat storage material (25) configured to absorb heat due to phase change, and
wherein the plurality of pores (23) disposed in the at least one portion of the second region (22) are provided to be filled with the heat storage material (25).

2. The display apparatus of claim 1, wherein the first region (21) is provided as a non-porous region.

3. The display apparatus of claim 2, wherein the first region (21') is provided to extend from the front surface to one portion disposed between the front surface and a half of a thickness of the frame (20).

4. The display apparatus of claim 1, wherein the plurality of pores (23) are provided to have diameters which increase in the direction from the front surface toward the rear surface (24).

5. The display apparatus of claim 1, wherein the second region (22) further includes a third surface formed of a non-porous material at one side of the second region (22),
wherein the third surface is provided to be exposed at the outside of the display apparatus.

6. The display apparatus of claim 1, wherein at least one portion of the second region (22) is provided to be exposed at the outside of the display apparatus.

7. The display apparatus of claim 1, further comprising an electronic part (30) electrically connected to the printed circuit board (12),
wherein heat generated by the electronic part (30) is dissipated to the plurality of outlets (41) through the second region (22).

8. The display apparatus of claim 7, wherein the frame (20) further includes a seating space (20a) provided so that the electronic part (30) is seated inside the frame (20).

9. The display apparatus of claim 8, wherein the electronic part (30) is provided inside the seating space (20a) to be in contact with at least one portion of the frame (20).

10. The display apparatus of claim 1, wherein the plurality of LEDs (11) mounted on the printed circuit board (12) are provided to directly display an image.

11. The display apparatus of claim 1, further comprising an image display panel configured to display an image,
wherein the plurality of LEDs (11) mounted on the printed circuit board (12) are provided to emit light to the image display panel.

12. The display apparatus of claim 1, wherein the frame (20) is coupled to the cover member (40) in a state in which a rear surface (24) of the printed circuit board (12) is in contact with the front surface of the frame (20).

## Patentansprüche

1. Anzeigevorrichtung, umfassend:
eine Leiterplatte (12), auf der eine Vielzahl von Leuchtdioden, LEDs, (11) angebracht ist;
einen Rahmen (20), der eine Vorderseite aufweist, die zum Tragen der Leiterplatte (12) konfiguriert ist; und
ein Abdeckelement (40), das eine Rückseite (24) des Rahmens (20) abdeckt,
wobei der Rahmen (20) einen ersten Bereich (21), der sich in einer Richtung von der Vorderseite zu der Rückseite (24) erstreckt, und einen zweiten Bereich (22), der eine Vielzahl von Poren (23) aufweist, die zwischen dem ersten Bereich (21) und der Rückseite (24) ausgebildet sind, aufweist, und
das Abdeckelement (40) eine Vielzahl von Auslässen (41) aufweist, wobei
Wärme, die von der Leiterplatte (12) erzeugt wird, zu der Vielzahl von Auslässen (41) durch den ersten Bereich (21) und die Vielzahl von Poren (23) konvektiert wird, und
**dadurch gekennzeichnet, dass**
mindestens ein Abschnitt (22a) des zweiten Bereichs (22) ein Wärmespeichermaterial (25) enthält, das so konfiguriert ist, dass es durch eine Phasenänderung bedingte Wärme absorbiert, und
wobei die Vielzahl von Poren (23), die in dem mindestens einen Abschnitt des zweiten Bereichs (22) angeordnet sind, vorgesehen sind, um mit dem Wärmespeichermaterial (25) gefüllt zu werden.

2. Anzeigevorrichtung nach Anspruch 1, wobei der erste Bereich (21) als nicht-poröser Bereich vorgesehen ist.

3. Anzeigevorrichtung nach Anspruch 2, wobei der erste Bereich (21') so vorgesehen ist, dass er sich von der Vorderseite bis zu einem Abschnitt erstreckt, der zwischen der Vorderseite und einer Hälfte einer Dicke des Rahmens (20) angeordnet ist.

4. Anzeigevorrichtung nach Anspruch 1, wobei die Vielzahl von Poren (23) so bereitgestellt wird, dass sie Durchmesser aufweist, die in Richtung von der Vorderseite zur Rückseite (24) hin zunehmen.

5. Anzeigevorrichtung nach Anspruch 1, wobei der zweite Bereich (22) ferner eine dritte Oberfläche aufweist, die aus einem nicht-porösen Material auf einer Seite des zweiten Bereichs (22) ausgebildet ist,
wobei die dritte Oberfläche so vorgesehen ist, dass sie an der Außenseite der Anzeigevorrichtung freiliegt.

6. Anzeigevorrichtung nach Anspruch 1, wobei mindestens ein Abschnitt des zweiten Bereichs (22) so vorgesehen ist, dass er an der Außenseite der Anzeigevorrichtung freiliegt.

7. Anzeigevorrichtung nach Anspruch 1, ferner umfassend ein elektronisches Teil (30), das elektrisch mit der Leiterplatte (12) verbunden ist,
wobei die von dem elektronischen Teil (30) erzeugte Wärme über den zweiten Bereich (22) an die Vielzahl von Auslässen (41) abgeleitet wird.

8. Anzeigevorrichtung nach Anspruch 7, wobei der Rahmen (20) ferner einen Sitzraum (20a) aufweist, der so vorgesehen ist, dass das elektronische Teil (30) innerhalb des Rahmens (20) sitzt.

9. Anzeigevorrichtung nach Anspruch 8, wobei das elektronische Teil (30) innerhalb des Sitzraums (20a) vorgesehen ist, um mit mindestens einem Abschnitt des Rahmens (20) in Kontakt zu sein.

10. Anzeigevorrichtung nach Anspruch 1, wobei die Vielzahl von LEDs (11), die auf der Leiterplatte (12) angebracht sind, zur direkten Anzeige eines Bildes vorgesehen sind.

11. Anzeigevorrichtung nach Anspruch 1, ferner umfassend eine Anzeigetafel, die zur Anzeige eines Bildes konfiguriert ist,
wobei die Vielzahl von LEDs (11), die auf der Leiterplatte (12) angebracht ist, vorgesehen ist, um Licht an die Anzeigetafel zu emittieren.

12. Anzeigevorrichtung nach Anspruch 1, wobei der Rahmen (20) mit dem Abdeckelement (40) in einem Zustand gekoppelt ist, in dem eine Rückseite (24) der Leiterplatte (12) mit der Vorderseite des Rahmens (20) in Kontakt ist.

## Revendications

1. Dispositif d'affichage, comprenant :
une carte de circuit imprimé (12) sur laquelle sont montées plusieurs diodes électroluminescentes, DEL, (11) ;
un cadre (20) comprenant une surface avant configurée pour supporter la carte de circuit imprimé (12) ; et
un élément de couverture (40) qui recouvre la surface arrière (24) du cadre (20),
dans lequel le cadre (20) comprend une première région (21) s'étendant dans une direction allant de la surface avant vers la surface arrière (24) et une deuxième région (22) comprenant une pluralité de pores (23) formés entre la première région (21) et la surface arrière (24), et
l'élément de couverture (40) comprend une pluralité de sorties (41), dans lequel
la chaleur générée par la carte de circuit imprimé (12) est convectée vers la pluralité de sorties (41) à travers la première région (21) et la pluralité de pores (23), et
**caractérisé en ce que**
au moins une partie (22a) de la deuxième région (22) comprend un matériau de stockage de chaleur (25) configuré pour absorber la chaleur due au changement de phase, et
dans lequel la pluralité de pores (23) disposés dans l'au moins une partie de la deuxième région (22) est prévue pour être remplie par le matériau de stockage de chaleur (25).

2. Dispositif d'affichage de la revendication 1, dans lequel la première région (21) est prévue comme une région non poreuse.

3. Dispositif d'affichage de la revendication 2, dans lequel la première région (21') est prévue pour s'étendre de la surface avant à une partie disposée entre la surface avant et la moitié d'une épaisseur du cadre (20).

4. Dispositif d'affichage de la revendication 1, dans lequel la pluralité de pores (23) est prévue pour avoir des diamètres qui augmentent dans la direction de la surface avant vers la surface arrière (24).

5. Dispositif d'affichage de la revendication 1, dans lequel la deuxième région (22) comprend en outre une troisième surface formée d'un matériau non poreux sur un côté de la deuxième région (22),
dans lequel la troisième surface est prévue pour être exposée à l'extérieur du dispositif d'affichage.

6. Dispositif d'affichage de la revendication 1, dans lequel au moins une partie de la deuxième région (22) est prévue pour être exposée à l'extérieur du dispositif d'affichage.

7. Dispositif d'affichage de la revendication 1, comprenant en outre une partie électronique (30) connectée électriquement à la carte de circuit imprimé (12),
dans lequel la chaleur générée par la partie électronique (30) est dissipée vers la pluralité de sorties (41) à travers la deuxième région (22).

8. Dispositif d'affichage de la revendication 7, dans lequel le cadre (20) comprend en outre un espace d'assise (20a) prévu pour que la partie électronique (30) soit assise à l'intérieur du cadre (20).

9. Dispositif d'affichage de la revendication 8, dans lequel la partie électronique (30) est prévue à l'intérieur de l'espace d'assise (20a) pour être en contact avec au moins une partie du cadre (20).

10. Dispositif d'affichage de la revendication 1, dans lequel la pluralité de DEL (11) montées sur la carte de circuit imprimé (12) est prévue pour afficher directement une image.

11. Dispositif d'affichage de la revendication 1, comprenant en outre un panneau d'affichage d'image configuré pour afficher une image,
dans lequel la pluralité de DEL (11) montées sur la carte de circuit imprimé (12) est prévue pour émettre de la lumière vers le panneau d'affichage d'image.

12. Dispositif d'affichage de la revendication 1, dans lequel le cadre (20) est couplé à l'élément de couverture (40) dans un état dans lequel une surface arrière (24) de la carte de circuit imprimé (12) est en contact avec la surface avant du cadre (20).
